Europäisches Patentamt

European Patent Office

Office européen des brevets

(11) Numéro de publication : **0 375 570 B1**

(12) **FASCICULE DE BREVET EUROPEEN**

(45) Date de publication du fascicule du brevet :
02.11.95 Bulletin 95/44

(51) Int. Cl.[6] : **H01L 41/04,** H01L 41/08,
H03H 11/44

(21) Numéro de dépôt : 89420496.5

(22) Date de dépôt : 18.12.89

(54) **Dispositif d'absorption des vibrations comportant un élément piézoélectrique.**

(30) Priorité : 19.12.88 FR 8817046

(43) Date de publication de la demande :
27.06.90 Bulletin 90/26

(45) Mention de la délivrance du brevet :
02.11.95 Bulletin 95/44

(84) Etats contractants désignés :
DE GB

(56) Documents cités :
US-A- 4 156 823
FUNKSCHAU. no. 5, 02 mars 1984, MUNCHEN
DE, pages 51 - 52; M. KÜPER:
"LAUTSPRECHER"
TOUTE L'ELECTRONIQUE. no. 419, mars 1977,
PARIS FR, pages 55-58; R. HOUZE: "Etude
pratique du circuit "N.I.C.""
"Les capteurs en instrumentation industrielle" par G. ASCH, ed. Dunod, Paris; page 428

(73) Titulaire : **METRAVIB R.D.S. Société Anonyme
64, Chemin des Mouilles
B.P. 182
F-69132 Ecully Cédex (FR)**

(72) Inventeur : **Merzeau, Pascal
Le Gonichon
Brussieu
F-69690 Bessenay (FR)**

(74) Mandataire : **Ropital-Bonvarlet, Claude
Cabinet BEAU DE LOMENIE
51, avenue Jean-Jaurès
B.P. 7073
F-69301 Lyon Cédex 07 (FR)**

## Description

La présente invention concerne le domaine technique des corps ou éléments, au sens général, du type piézoélectrique, capables de transformer de l'énergie mécanique ou acoustique en énergie électrique, ou inversement.

L'invention vise, plus précisément, les dispositifs d'absorption des vibrations comprenant des moyens associés à un élément piézoélectrique pour le conditionner en relation avec l'application à laquelle l'élément est destiné.

Il doit, tout d'abord, être considéré que, dans certaines applications spécifiques, il convient de pouvoir disposer d'un matériau dont les caractéristiques mécaniques, à savoir, essentiellement, la raideur et l'amortissement, peuvent être modifiées à volonté et indépendamment l'une de l'autre. Ce besoin apparaît, par exemple, pour la réalisation de panneaux adaptés pour absorber des ondes sonores. Un autre exemple de besoin exprimé est l'obtention d'un matériau de recouvrement adapté et employé dans la technique dite du "revêtement simple" consistant à réduire l'amplitude des vibrations que prend une structure lors de ses résonances.

Par ailleurs, il doit être constaté que les éléments piézoélectriques constituent des éléments ayant fait l'objet d'études approfondies et trouvant des applications diverses comme, par exemple, la détection de grandeurs physiques, la génération de signaux ou le filtrage de fréquences. Plus récemment, des moyens, visant la réduction des amplitudes vibratoires d'une structure, ont été proposés, mais selon des méthodes classiques d'asservissement pour lesquelles le rôle de l'élément piézoélectrique est uniquement moteur.

Les éléments piézoélectriques possèdent des propriétés mécaniques qui sont déterminées au cours de leur fabrication, en relation avec le ou les matériaux les constituant et leurs dimensions présentées. Les propriétés mécaniques des éléments piézoélectriques, à savoir, essentiellement, la raideur et l'amortissement, restent, pratiquement, inchangées au cours de leur utilisation, sauf sous l'effet d'une forte élévation de température qui constitue, généralement, une grandeur d'influence non contrôlée.

Il semble donc que les éléments piézoélectriques ne sont pas adaptés pour être mis en oeuvre dans des applications nécessitant une modification de la raideur et de l'amortissement du matériau utilisé.

L'état de la technique a proposé par le brevet **US-A-4 156 823** un procédé adapté pour améliorer les caractéristiques de réponse d'un capteur ultrasonore du type électrostrictif. A cet effet, le procédé consiste à connecter, entre les bornes du capteur, une résistance ohmique et, à travers un convertisseur d'impédance négative, une impédance de charge. Ce procédé permet de compenser les composants qui gênent les caractéristiques d'amortissement du capteur.

La présente invention vise à proposer un dispositif permettant de modifier à volonté et pour des valeurs importantes, les propriété mécaniques d'un élément piézoélectrique, en relation avec l'application visée.

L'invention vise, également, à offrir un dispositif adapté pour modifier les propriétés mécaniques d'un élément piézoélectrique, de manière que l'élément puisse répondre différemment, suivant les besoins, à une sollicitation mécanique extérieure mais, également, à une excitation électrique pour provoquer un déplacement de l'élément.

L'invention vise, aussi, à proposer un dispositif conçu pour modifier les propriétés mécaniques d'un élément piézoélectrique, de façon quasi instantanée et précise.

Pour atteindre les buts énoncés ci-dessus, le dispositif d'absorption des vibrations comporte :
- au moins un élément piézoélectrique du type comportant une capacité électrique et une capacité représentant l'élasticité de l'élément,
- une résistance ohmique connectée aux bornes de l'élément,
- et une impédance de charge, constituée par au moins une capacité et connectée aux bornes de l'élément à travers un convertisseur d'impédance négative.

Selon l'invention, le dispositif d'absorption des vibrations, pour modifier les propriétés mécaniques de l'élément piézoélectrique, est caractérisé en ce :
- la résistance ohmique présente une valeur adaptée pour assurer la dissipation de l'énergie vibratoire,
- et en ce que la capacité de l'impédance de charge est choisie de manière que la capacité résultante, correspondant à la somme des capacités, soit sensiblement nulle.

Diverses autres caractéristiques ressortent de la description faite ci-dessous en référence aux dessins annexés qui montrent, à titre d'exemples non limitatifs, des formes de réalisation de l'objet de l'invention.

Les **fig. 1** et **2** sont des vues de schémas permettant de mettre en évidence l'invention.

La **fig. 3** est une vue d'un exemple de réalisation pratique d'un dispositif selon l'invention suivant une première variante préférée d'exécution.

La **fig. 4** est un graphique montrant les modifications des caractéristiques d'un élément piézoélectrique d'un dispositif selon l'invention.

La **fig. 5** est une vue d'un autre exemple de réalisation pratique d'un dispositif selon l'invention suivant la première variante d'exécution.

La **fig. 6** est une vue d'un exemple de réalisation pratique d'un dispositif selon l'invention suivant une seconde variante préférée d'exécution.

La **fig. 7** illustre un autre dispositif selon l'invention.

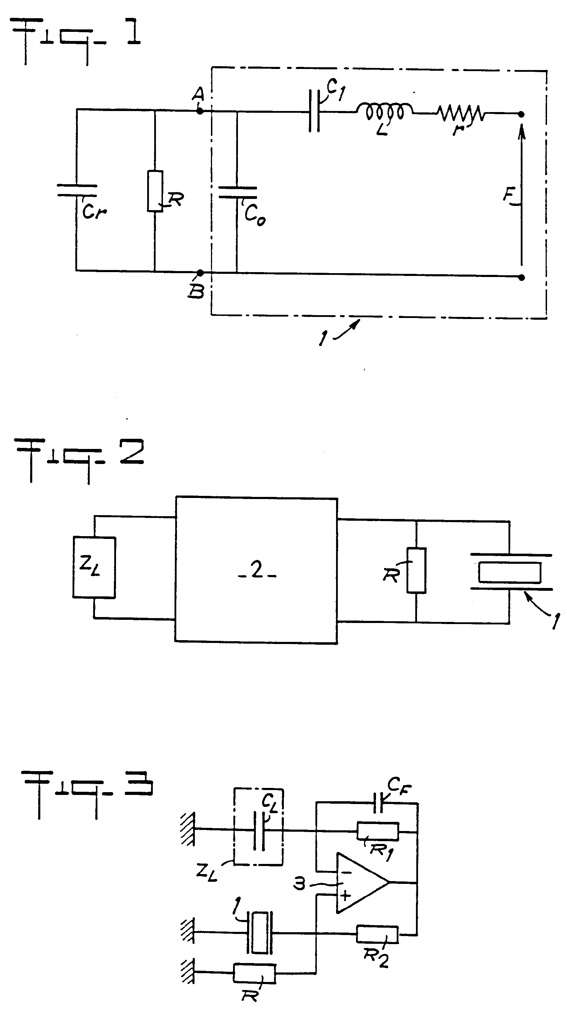

La **fig. 1** illustre l'invention, permettant le conditionnement d'un matériau ou élément piézoélectrique **1**, de nature et de forme diverses en relation avec l'application visée.

L'élément piézoélectrique **1**, qui a été représenté par son schéma électrique équivalent, connu en soi, comporte, d'une part, une capacité $C_o$, représentant la capacité électrique de l'élément apparaissant entre les deux électrodes **A** et **B** de l'élément et, d'autre part, un circuit motionnel formé d'une capacité $C_1$ représentant l'élasticité de l'élément, une inductance **L** représentant la masse et une résistant **r** correspondant aux pertes mécaniques. Le schéma indique, également, la force **F** à laquelle l'élément est soumis.

Par souci de simplification de la description de l'invention, il doit être considéré que les condensateurs seront désignés par leur valeur de capacité et les selfs par leur valeur d'inductance.

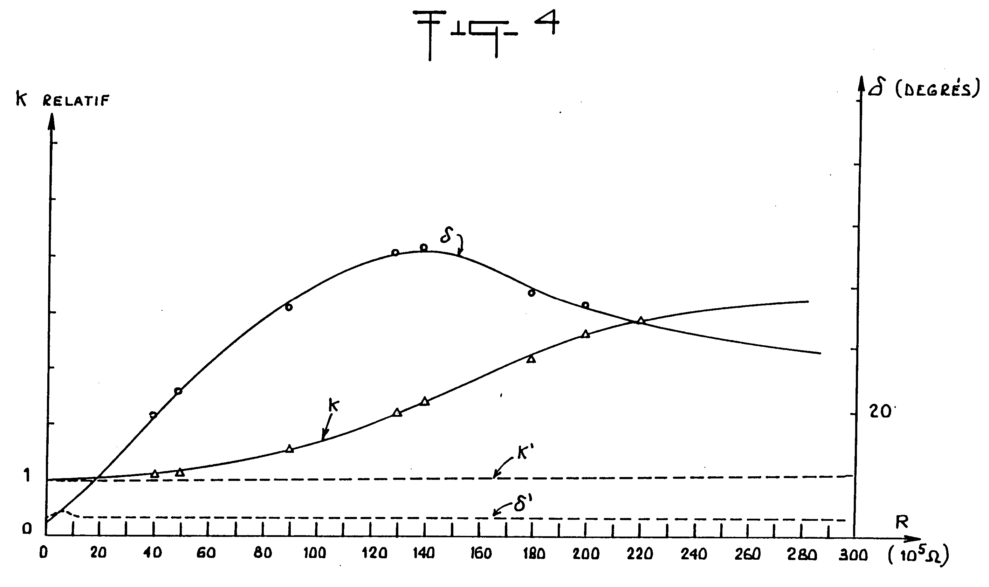

L'invention consiste notamment à connecter en parallèle, entre les deux bornes **A**, **B** de l'élément piézoélectrique, d'une part, une résistance ohmique **R** de dissipation dont la fonction sera mieux comprise dans la description qui suit et, d'autre part, une capacité négative $C_r$ déterminée. Tel que cela apparaît plus précisément à la **fig. 2**, la capacité négative $C_r$ ramenée aux bornes de l'élément, est obtenue en connectant, aux bornes de l'élément **1**, une impédance de charge $Z_L$ par l'intermédiaire d'un convertisseur d'impédance négative **2**.

Ceci permet de réduire la valeur de la capacité électrique $C_o$ de l'élément piézoélectrique, en ramenant une capacité négative $C_r$ aux bornes de l'élément, autorise la modification indirecte de la valeur du coefficient de couplage de l'élément dont l'évolution est significative de l'écart entre les modules complexes de l'élément à champ constant et à induction constante. Les propriétés mécaniques de l'élément, à savoir l'amortissement, la raideur, les modules apparents et les fréquences de résonance, peuvent donc être modifiées à volonté suivant les besoins de l'application, en choisissant judicieusement les valeurs de la résistance de dissipation **R** et de la capacité négative $C_r$.

Pour un choix optimum de la capacité $C_r$, le choix de la valeur de la résistance de dissipation **R**, de valeur non nulle, assure un éventail très large de raideur et, surtout, d'amortissement au niveau de l'élément piézoélectrique. La valeur de la résistance **R** est, en effet, déterminée pour maîtriser la dissipation de l'énergie ayant une origine mécanique ou vibratoire. La mise en oeuvre d'une résistance de dissipation **R**, en combinaison avec l'association d'un convertisseur d'impédance négative et d'un élément piézoélectrique, permet donc d'obtenir des variations très importantes des modules complexes de l'élément et d'utiliser le procédé selon l'invention dans de nombreuses applications.

Selon l'invention, la capacité négative $C_r$ ramenée est déterminée de manière que la capacité résultante $C_{res}$, correspondant à la somme des capacités $C_r$ et $C_o$, est égale sensiblement à zéro. Cette condition **(1)** peut être exprimée, également, sous la forme :

$$C_r \simeq - C_o$$

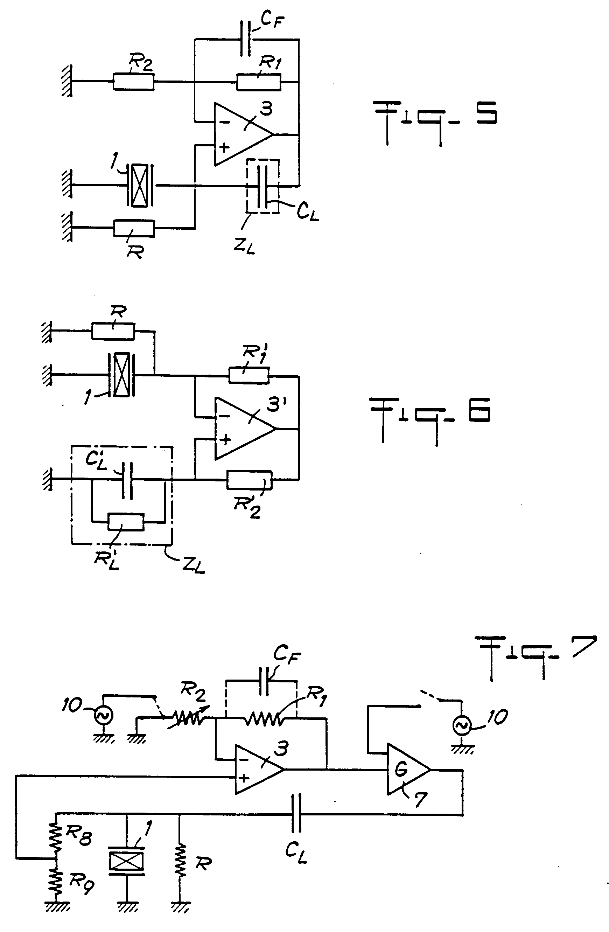

La **fig. 3** illustre un exemple de configuration d'un convertisseur d'impédance négative **2**, pour lequel la condition **(1)** est respectée. Le convertisseur d'impédance négative est constitué par un amplificateur opérationnel **3** comportant, dans sa boucle de contre-réaction négative, une résistance $R_1$ et, dans sa boucle de contre-réaction positive, une résistance $R_2$. L'entrée inverseuse de l'amplificateur opérationnel **3** est reliée à l'impédance de charge $Z_L$ constituée par une capacité $C_L$. L'entrée non inverseuse de l'amplificateur **3** est connectée à la résistance **R** et à l'une des bornes de l'élément piézoélectrique **1**. La capacité $C_r$, ramenée aux bornes de l'élément piézoélectrique, est telle que :

$$C_r = - \frac{R_1}{R_2} . C_L$$

De préférence, un condensateur de filtrage $C_F$ est monté en parallèle sur la résistance $R_1$, afin de réduire la bande passante du montage.

Le respect de la condition **(1)** permet d'obtenir une modification des propriétés mécaniques dans le sens où l'élément piézoélectrique devient, à la fois, raide et très amortissant.

Une telle modification des propriétés mécaniques d'un élément piézoélectrique permet d'obtenir l'amortissement des vibrations.

Un tel procédé peut être mis en oeuvre, par exemple, dans la technique du revêtement simple. Ainsi, il peut être envisagé de remplacer la couche de matériau viscoélastique, recouvrant une structure métallique du type poutre ou plaque, par un élément piézoélectrique associé à un convertisseur d'impédance négative et à une résistance de dissipation, tel que décrit précédemment.

La **fig. 4** permet de mettre en évidence les modifications de propriétés mécaniques d'un tel élément piézoélectrique sollicité, par exemple, en flexion et auquel le procédé selon l'invention est appliqué. Lorsque la condition **(1)** est respectée, la variation de la résistance de dissipation **R** entraîne une modification de raideur **K** et d'amortissement $\eta = $ **tg** $(\delta)$ de l'élément piézoélectrique. A titre de comparaison, la **fig. 4** montre les courbes de variation de l'amortissement $\eta' = $ **tg** $(\delta')$ et de raideur **K'** d'un même élément piézoélectrique connecté uniquement à la résistance **R**.

Le dispositif selon l'invention permet d'obtenir une augmentation des valeurs d'amortissement et de raideur de l'élément piézoélectrique qui présente un module nettement supérieur pour une valeur de résistance équivalente.

De plus, le maximum d'amortissement est obtenu pour une valeur intermédiaire de raideur. Le maximum d'amortissement est atteint lorsque :

$$R = 1/(\omega \, [C_{res} \, (C_{res} + \, C_1)]^{1/2})$$

en basse fréquence, ou :

$$R = 1/(\omega. \, C_{res})$$

au voisinage des résonances, avec $\omega$ étant la pulsation.

Dans cet exemple de réalisation, l'élément piézoélectrique est constitué par un polymère piézoélectrique comme, par exemple, le polyfluorure de vinylidène ou, de préférence, par une céramique.

Le revêtement simple, utilisant des éléments céramiques selon le procédé conforme à l'invention, autorise la réalisation d'amortissement à haute température permettant d'éviter l'utilisation de produits viscoélastiques qui, pour la plupart, vieillissent mal en atmosphère oxydante, même si leur température de transition est élevée.

La **fig. 5** illustre un autre exemple de configuration du convertisseur d'impédance négative **2**, pour lequel la condition **(1)** est respectée. Le convertisseur d'impédance négative est constitué par l'amplificateur 3 comportant, dans sa boucle de contre-réaction négative, la résistance $R_1$ et, dans sa boucle de contre-réaction positive, la capacité $C_L$. L'entrée inverseuse de l'amplificateur 3 est connectée à la résistance $R_2$, tandis que l'entrée non inverseuse est reliée à la résistance $\underline{R}$ et à l'une des bornes de l'élément piézoélectrique $\underline{1}$.

Selon une autre variante préférée de réalisation de l'invention, la capacité négative $C_r$, ramenée aux bornes de l'élément piézoélectrique, est déterminée de manière que la capacité résultant $C_{res}$, correspondant à la somme des capacités $C_r$ et $C_o$, soit égale sensiblement à la capacité $C_1$ affectée du signe négatif ou soit la condition **(2)** :

$$C_{res} = C_o + C_r \simeq - C_1$$

La **fig. 6** illustre un exemple de configuration d'un convertisseur d'impédance négative, pour lequel la condition **(2)** est respectée. Le convertisseur d'impédance négative **2** est constitué par un amplificateur opérationnel 3′ comportant, dans sa boucle de contre-réaction négative, une résistance $R'_1$ et dans sa boucle de contre-réaction positive, une résistance $R'_2$. L'entrée non inverseuse de l'amplificateur 3′ est reliée à l'impédance de charge $Z_L$ constituée par une résistance $R'_L$ montée en parallèle avec une capacité $C'_L$. L'entrée inverseuse de l'amplificateur 3′ est connectée à la résistance $\underline{R}$ et à l'une des bornes de l'élément piézoélectriqe 1. La capacité $C_r$, ramenée aux bornes de l'élément 1 est telle que :

$$C_r = - \frac{R'_2}{R'_1}. \, C'_L$$

La mise en oeuvre de la condition **(2)** permet d'obtenir un ramolissement de l'élément piézoélectrique.

La modification des propriétés mécaniques de l'élément piézoélectrique, dans le sens indiqué ci-dessus, peut être mise à profit pour appliquer le procédé selon l'invention à la réalisation de panneaux anéchoïdes, c'est-à-dire des panneaux adaptés pour absorber des ondes sonores. De préférence, un tel panneau peut être constitué par un polymère piézoélectrique associé à un convertisseur d'impédance négative et à une résistance de dissipation $\underline{R}$. Ce panneau, formé d'un matériau piézoélectrique, permet de remplacer, avantageusement, les matériaux utilisés dans l'art antérieur qui présentent un mauvais comportement en pression, en raison de la présence d'une forte proportion d'air pour obtenir une fréquence de résonance très faible pour une épaisseur déterminée.

Selon l'invention, la fréquence de résonance en circuit ouvert peut être réduite pour tendre, en théorie, vers zéro. Par ailleurs, la valeur de la résistance de dissipation $\underline{R}$ est déterminée de manière à assurer une bonne adaptation d'impédance mécanique avec le milieu de propagation des ondes sonores.

A titre d'exemple, une feuille en polyfluorure de vinylidène, d'épaisseur 1 mm et de 10 cm de côté, présente, dans l'application du procédé selon l'invention, un premier mode d'épaisseur se situant autour de 750 kHz. La mise en oeuvre de la condition **(2)** du procédé selon l'invention, à la feuille piézoélectrique décrite ci-dessus, permet de réduire au mieux la fréquence de résonance à 75 kHz. Une telle feuille permet, à une onde incidente, d'être pratiquement totalement transmise à l'intérieur de la feuille et de connaître un aller-retour avant de ressortir de celle-ci avec la même facilité. Cependant, l'onde a subi, entretemps, deux fois la perte par insertion qualifiant la fonction de barrière acoustique de la feuille. Ainsi, le facteur de réflexion est alors d'au moins - 27 dB à la fréquence de résonance de 75 kHz.

De tels panneaux anéchoïdes jouant, en même temps, le rôle de barrières acoustiques, peuvent être mis en oeuvre, par exemple dans les techniques d'acoustique sous-marine ou aérienne. Dans ce dernier cas, il convient d'employer des éléments piézoélectriques alvéolaires.

Une autre application de l'invention, en relation avec la mise en oeuvre de la condition **(2)**, concerne la réalisation de transducteurs basse fréquence qui peuvent être réalisés sous faible volume, en raison de la réduction de la fréquence de résonance pour un élément de mêmes dimensions.

Une autre application particulière a trait à la réalisation de transducteurs résonnants présentant une fréquence d'accord ajustable en réglant à volonté la résistance de dissipation et/ou la capacité ramenée aux bornes de l'élément piézoélectrique.

Bien entendu, il peut être envisagé d'autres applications, données ci-après à titre non limitatif, telles que, par exemple, la réalisation de suspensions ajustables en raideur et en amortissement, d'éléments de structure amortis et d'amortissement pour les tuyauteries.

Dans certaines applications, l'élément piézoélectrique est soumis à des déformations de grandes amplitudes, de sorte que les tension électriques subies ou délivrées par le convertisseur d'impédance négative peuvent devenir considérables, d'autant plus que la compensation capacitive est mieux réalisée.

Pour remédier à cet inconvénient, il est avantageux de produire de la haute tension uniquement aux bornes de l'élément piézoélectrique, de manière que le convertisseur d'impédance négative reste à basse tension.

Pour assumer cette fonction, il peut être envisagé, par exemple, conformément à la **fig. 7**, d'adapter un amplificateur haute tension **7** entre la sortie de l'amplificateur opérationnel **3** et la capacité de charge $C_L$, d'une part, et d'interposer, entre l'entrée non inverseuse de l'amplificateur opérationnel **3** et l'élément piézoélectrique **1**, un pont diviseur de tension présentant une impédance totale très grande devant celle de la résistance de dissipation $\underline{R}$ ou constituant, par lui-même, la résistance de dissipation, d'autre part. Le pont diviseur de tension est constitué par deux résistances $R_8$, $R_9$ montées en série aux bornes de l'élément piézoélectrique et dont le point milieu des deux résistances est relié à l'entrée non inverseuse de l'amplificateur opérationnel **3**. De préférence, les valeurs des résistances sont choisies de manière que :

$$R_9/(R_9 + R_8) \simeq 1/G$$

avec **G** le gain de l'amplificateur **7**.

Bien entendu, l'amplificateur haute tension **7** peut être adapté sur les autres exemples de configuration du convertisseur d'impédance négative **2**. Ainsi, l'amplificateur **7** peut être connecté directement à la sortie de l'amplificateur opérationnel **3**, **3'** en étant placé dans une boucle de contre-réaction pour attaquer indirectement l'élément piézoélectrique **1** et la résistance $\underline{R}$, par l'intermédiaire de la résistance $R_2$ (**fig. 3**) ou de la résistance $R'_1$ (**fig. 6**).

Il doit être considéré que la description de l'invention a été établie en relation avec un élément piézoélectrique devant présenter un comportement particulier, en réponse à une sollicitation ou force extérieure. Bien entendu, l'invention peut être mis en oeuvre pour modifier les propriétés mécaniques d'un élément piézoélectrique dont le déplacement est provoqué, en partie, par une source électrique, en absence ou en présence de sollicitation mécanique extérieure.

Tel que cela apparaît à la **fig. 7**, une telle source électrique peut être constituée par un générateur de tension **10** connecté, soit sur une entrée de l'amplificateur haute tension **7**, soit à l'entrée inverseuse de l'amplificateur opérationnel **3**, à travers la résistance $R_2$.

Par ailleurs, il peut apparaître, en fonction des conditions d'environnement, une dérive des composants du dispositif permettant de mettre en oeuvre le procédé selon l'invention. Une façon particulièrement avantageuse de compenser la dérive de la capacité interélectrodes $C_o$ de l'élément piézoélectrique qui peut se produire lors d'une variation uniforme de température, est de prendre, pour constituer la capacité $C_L$ ou $C'_L$, une partie métallisée, mais non active, de l'élément piézoélectrique, afin de maintenir les conditions **(1)** et **(2)**.

L'invention n'est pas limitée aux exemples décrits et représentés, car diverses modifications peuvent y être apportées sans sortir de son cadre défini par les revendications annexées.

## Revendications

1. Dispositif d'absorption des vibrations, comportant :
   - au moins un élément piézoélectrique (**1**), du type comportant une capacité électrique ($C_0$) et une capacité ($C_1$) représentant l'élasticité de l'élément,
   - une résistance ohmique ($\underline{R}$) connectée aux bornes de l'élément,
   - et une impédance de charge ($Z_L$), constituée par au moins une capacité ($C_L$, $C'_L$) et connectée aux bornes de l'élément à travers un convertisseur d'impédance négative (**2**),
   
   caractérisé en ce que, pour modifier les propriétés mécaniques de l'élément piézoélectrique :
   - la résistance ohmique ($\underline{R}$) présente une valeur adaptée pour assurer la dissipation de l'énergie vibratoire,
   - et la capacité ($C_L$, $C'_L$) de l'impédance de charge ($Z_L$) est choisie de manière que la capacité résultante ($C_{res}$), correspondant à la somme des capacités ($C_r$) et ($C_0$), soit sensiblement nulle.

2. Dispositif selon la revendication 1, caractérisé en ce que la résistance ohmique ($\underline{R}$) est une résistance variable.

3. Dispositif selon la revendication 1 ou 2, caractérisé en ce que la résistance ohmique ($\underline{R}$) présente, au voisinage des fréquences de résonance, une valeur égale à $1/(C_{res}.\omega)$, avec $\omega$ la pulsation.

4. Dispositif selon la revendication 1 ou 2, caractérisé en ce que la résistance ohmique ($\underline{R}$) présente, au voisinage des résonances, une valeur égale à

$$R = 1/(\omega [C_{res} (C_{res} + C_1)]^{1/2}).$$

5. Dispositif selon la revendication 1, caractérisé en ce que la capacité ($C'_L$) de l'impédance de charge est placée en parallèle avec une résistance ($R'_L$).

6. Dispositif selon la revendication 1, caractérisé en ce que le convertisseur d'impédance négative est constitué par un amplificateur opérationnel (**3'**) comportant, dans la boucle de contre-réaction négative et celle positive, respectivement, une résistance ($R'_1$, $R'_2$), l'entrée inverseuse de l'amplificateur étant reliée à la résistance de dissipation ($R$) et à l'une des bornes de l'élément piézoélectrique, tandis que l'entrée non inverseuse de l'amplificateur est connectée à l'impédance de charge constituée par une résistance ($R'_L$) montée en parallèle avec une capacité ($C'_L$).

7. Dispositif selon la revendication 1, caractérisé en ce que le convertisseur d'impédance négative est constitué par un amplificateur opérationnel (**3**) comportant, dans la boucle de contre réaction négative et celle positive, respectivement, une résistance ($R_1$, $R_2$), l'entrée inverseuse de l'amplificateur étant reliée à l'impédance de charge constituée par une capacité ($C_L$), tandis que l'entrée non inverseuse est reliée à la résistance de dissipation ($R$) et à l'une des bornes de l'élément piézoélectrique.

8. Dispositif selon la revendication 1, caractérisé en ce que le convertisseur d'impédance négative est constitué par un amplificateur opérationnel (**3**) comportant, dans la boucle de contre réaction négative, une résistance ($R_1$) et, dans la boucle de contre-réaction positive, l'impédance de charge constituée par une capacité ($C_L$), l'entrée inverseuse de l'amplificateur étant reliée à une résistance ($R_2$), tandis que l'entrée non inverseuse est connectée à la résistance de dissipation et à l'une des bornes de l'élément piézoélectrique.

9. Dispositif selon la revendication 6, 7 ou 8, caractérisé en ce qu'il comporte, d'une part, un amplificateur haute tension (**7**) connecté directement à la sortie de l'amplificateur opérationnel (**3, 3'**) en étant placé dans une boucle de contre-réaction pour attaquer indirectement l'élément piézoélectrique (**1**) et la résistance (**R**) et, d'autre part, un pont diviseur de tension placé entre l'élément piézoélectrique et l'entrée correspondante de l'amplificateur opérationnel.

10. Dispositif selon la revendication 8, caractérisé en ce qu'il comporte un générateur de tension (**10**) connecté à l'entrée inverseuse de l'amplificateur opérationnel à travers la résistance ($R_2$).

11. Dispositif selon la revendication 9, caractérisé en ce qu'il comporte un générateur de tension (**10**) connecté sur une entrée auxiliaire de l'amplificateur haute tension (**7**).

12. Dispositif selon la revendication 6, 7 ou 8, caractérisé en ce qu'un condensateur de filtrage ($C_F$) est monté en parallèle sur la résistance placée dans la boucle de contre-réaction négative de l'amplificateur opérationnel.

13. Dispositif selon l'une des revendications 6 à 8, caractérisé en ce que le condensateur ($C_L$, $C'_L$) est constitué par une partie métallisée non active de l'élément piézoélectrique (**1**).

**Claims**

1. An apparatus for absorbing vibration, comprising:
   - at least one piezoelectric member (1) of the type comprising an electric capacitor ($C_0$) and a capacitor ($C_1$) representing the elasticity of the member,
   - an ohmic resistor ($R$) connected to the terminals of the member
   - and a load impedance ($Z_L$) made up of at least one capacitor ($C_L$, $C'_L$) and connected to the terminals of the member via a negative impedance converter (2),
   characterised in that, in order to change the mechanical properties of the piezoelectric member:
   - the ohmic resistor ($R$) has a value adapted to ensure dissipation of the vibration energy,
   - and the capacitance ($C_L$, $C'_L$) of the load impedance ($Z_L$) is selected so that the resultant capacitance ($C_{res}$), corresponding to the sum of the capacitances ($C_r$) and ($C_o$), is substantially zero.

2. An apparatus according to claim 1, characterised in that the ohmic resistance ($R$) is a variable resistance.

3. An apparatus according to claim 1 or 2, characterised in that the ohmic resistance ($R$) has a value equal to $1/C_{res}.\omega$) near the resonance frequencies, $\omega$ being the pulsation.

4. An apparatus according to claim 1 or 2, characterised in that the ohmic resistance ($R$) has a value equal to
$$R = 1/\omega \, [C_{res} \, (C_{res} + C_1)]^{1/2}$$
near the resonances.

5. An apparatus according to claim 1, characterised in that the capacitor ($C'_L$) of the load impedance is arranged in parallel with a resistor ($R'_L$).

6. An apparatus according to claim 1, characterised in that the negative impedance converter comprises an operational amplifier (3') with respective resistors (R'$_1$,R'$_2$) in its negative and positive feedback loops, the reversing input of the amplifier being connected to the dissipation resistor (R) and to one terminal of the piezoelectric member, while the non-reversing input of the amplifier is connected to the load impedance comprising a resistor (R'$_L$) mounted in parallel with a capacitor (C'$_L$).

7. An apparatus according to claim 1, characterised in that the negative impedance converter comprises an operational amplifier (3) with respective resistors (R$_1$, R$_2$) in its negative and positive feedback loops, the reversing input of the amplifier being connected to the load impedance comprising a capacitor (C$_L$), while the non-reversing input is connected to the dissipation resistor (R) and one terminal of the piezoelectric member.

8. An apparatus according to claim 1, characterised in that the negative impedance converter comprises an operational amplifier (3) with a resistor (R$_1$) in the negative feedback loop and the load impedance comprising a capacitor (C$_L$) in the positive feedback loop, the reversing input of the amplifier being connected to a resistor (R$_1$), while the non-reversing input is connected to the dissipation resistor and one terminal of the piezoelectric member.

9. An apparatus according to claim 6, 7 or 8, characterised in that it has (a) a high-voltage amplifier (7) connected directly to the output of the operational amplifier (3, 3'), being located in a negative feedback loop in order to act indirectly on the piezoelectric member (1) and resistor (R), and (b) a potential-dividing bridge located between the piezoelectric member and the corresponding input of the operational amplifier.

10. An apparatus according to claim 8, characterised in that it has a voltage generator (10) connected to the reversing input of the operational amplifier via a resistor (R$_2$).

11. An apparatus according to claim 9, characterised in that it has a voltage generator (10) connected to an auxiliary input of the high-voltage amplifier (7).

12. An apparatus according to claim 6, 7 or 8, characterised in that a filtering capacitor C$_F$) is mounted in parallel with the resistor located in the negative feedback loop of the operational amplifier.

13. An apparatus according to any of claims 6 to 8, characterised in that the capacitor (C$_L$, C'$_L$) comprises a metallised, non-active of the piezoelectric member (1).

**Patentansprüche**

1. Vorrichtung zur Absorption der Vibrationen, bestehend aus:
   - mindestens einem piezoelektrischen Element (1) des Typs mit einer elektrischen Kapazität (C$_0$) und einer Kapazität (C$_1$), die die Elastizität des Elements darstellt,
   - einem Ohm'schen Widerstand (R), der mit den Klemmen des Elements verbunden ist,
   - und einer Verbraucherimpedanz (Z$_L$), die aus mindestens einer Kapazität (C$_L$, C'$_L$) besteht und über einen Impedanzwandler negativer Impedanz (2) mit den Klemmen des Elements verbunden ist,
   dadurch gekennzeichnet, daß zur Änderung der mechanischen Eigenschaften des piezoelektrischen Elements:
   - der Ohm'sche Widerstand (R) einen geeigneten Wert hat, um die Dissipation der Vibrationsenergie zu gewährleisten,
   - und die Kapazität (C$_L$, C'$_L$) der Verbraucherimpedanz (Z$_L$) so gewählt ist, daß die resultierende Kapazität (C$_{res}$), die der Summe der Kapazitäten (C$_r$) und (Co) entspricht, im wesentlichen gleich Null ist.

2. Vorrichtung nach Anspruch 1, dadurch gekennzeichnet, daß der Ohm'sche Widerstand (R) ein variabler Widerstand ist.

3. Vorrichtung nach Anspruch 1 oder 2, dadurch gekennzeichnet, daß der Ohm'sche Widerstand (R) in der Nähe der Resonanzfrequenzen einen Wert von 1/(C$_{res}$.ω) hat, wobei ω die Frequenz ist.

4. Vorrichtung nach Anspruch 1 oder 2, dadurch gekennzeichnet, daß der Ohm'sche Widerstand (R) in der Nähe der Resonanzen einen Wert von
$$R = 1/(\omega[C_{res}(C_{res} + C_1)]^{1/2})$$
hat.

5. Vorrichtung nach Anspruch 1, dadurch gekennzeichnet, daß die Kapazität (C'$_L$) der Verbraucherimpedanz parallel mit einem Widerstand (R'$_L$) geschaltet ist.

6. Vorrichtung nach Anspruch 1, dadurch gekennzeichnet, daß der Impedanzwandler negativer Impedanz aus einem Operationsverstärker (3') besteht, der in der negativen und positiven Gegenkopplungs-Schleife einen Widerstand ($R'_1$ bzw. $R'_2$) aufweist, wobei der Umkehreingang des Verstärkers mit dem Dissipationswiderstand (R) und einer der Klemmen des piezoelektrischen Elements verbunden ist, während der nicht umkehrende Eingang des Verstärkers mit der Verbraucherimpedanz verbunden ist, die aus einem Widerstand ($R'_L$) besteht, der parallel mit einer Kapazität ($C'_L$) geschaltet ist.

7. Vorrichtung nach Anspruch 1,
dadurch gekennzeichnet, daß der Impedanzwandler negativer Impedanz aus einem Operationsverstärker (3) besteht, der in der negativen und positiven Gegenkopplungs-Schleife einen Widerstand ($R_1$ bzw. $R_2$) aufweist, wobei der Umkehreingang des Verstärkers mit der Verbraucherimpedanz verbunden ist, die aus einer Kapazität ($C_L$) besteht, während der nicht umkehrende Eingang mit dem Dissipationswiderstand (R) und einer der Klemmen des piezoelektrischen Elements verbunden ist.

8. Vorrichtung nach Anspruch 1,
dadurch gekennzeichnet, daß der Impedanzwandler negativer Impedanz aus einem Operationsverstärker (3) besteht, der in der negativen Gegenkopplungs-Schleife einen Widerstand ($R_1$) und in der positiven Gegenkopplungs-Schleife die Verbraucherimpedanz, die aus einer Kapazität ($C_L$) besteht, aufweist, wobei der Umkehreingang des Verstärkers mit einem Widerstand ($R_2$) verbunden ist, während der nicht umkehrende Eingang mit dem Dissipationswiderstand und einer der Klemmen des piezoelektrischen Elements verbunden ist.

9. Vorrichtung nach Anspruch 6, 7 oder 8,
dadurch gekennzeichnet, daß sie einerseits einen Hochspannungsverstärker (7) aufweist, der direkt mit dem Ausgang des Operationsverstärkers (3, 3') verbunden ist, wobei er sich in einer Gegenkopplungs-Schleife befindet, um das piezoelektrische Element (1) und den Widerstand (R) indirekt zu steuern, und andererseits eine Spannungsteiler-Brücke aufweist, die zwischen dem piezoelektrischen Element und dem entsprechenden Eingang des Operationsverstärkers angeordnet ist.

10. Vorrichtung nach Anspruch 8,
dadurch gekennzeichnet, daß sie einen Spannungserzeuger (10) aufweist, der über den Widerstand ($R_2$) mit dem Umkehreingang des Operationsverstärkers verbunden ist.

11. Vorrichtung nach Anspruch 9,
dadurch gekennzeichnet, daß sie einen Spannungserzeuger (10) aufweist, der mit einem Zusatzeingang des Hochspannungsverstärkers (7) verbunden ist.

12. Vorrichtung nach Anspruch 6, 7 oder 8,
dadurch gekennzeichnet, daß ein Filterkondensator ($C_F$) parallel mit dem Widerstand geschaltet ist, der sich in der negativen Gegenkopplungs-Schleife des Operationsverstärkers befindet.

13. Vorrichtung nach einem der Ansprüche 6 bis 8,
dadurch gekennzeichnet, daß der Kondensator ($C_L$, $C'_L$) aus einem nicht aktiven, metallbeschichteten Teil des piezoelektrischen Elements (1) besteht.

Fig. 1

Fig. 2

Fig. 3

Fig-4

Fig. 5

Fig. 6

Fig. 7